# EUROPEAN PATENT APPLICATION

(11) **EP 4 822 941 A1**
(43) Date of publication of application: **14.10.2026**
(21) Application number: 24900467.2
(22) Date of filing: 22.11.2024
(51) Int. Cl.: H02J 7/10, G01R 31/382, G01R 31/385, G01R 31/389, G01R 31/392, H01M 10/44, H01M 10/48, H02J 7/00

(54) **BATTERY CHARGING DEVICE, BATTERY CHARGING METHOD, AND BATTERY CHARGING PROGRAM**

(30) Priority: 04.12.2023 JP 2023204478
(71) Applicant: HORIBA, Ltd., Kyoto-shi Kyoto 601-8510 (JP)
(72) Inventor: MATSUNAGA, Shimpachi, Kyoto-shi, Kyoto 601-8510 (JP); TATSUKAWA, Shogo, Kyoto-shi, Kyoto 601-8510 (JP)
(74) Representative: Müller Hoffmann & Partner
(86) International application number: PCT/JP2024/041531
(87) International publication number: WO 2025/121172

(57) **Abstract**

The present invention efficiently measures an internal resistance used as a degradation index of a battery at time of charging the battery, and includes a battery charging unit 2 that supplies a charging current and/or voltage to the battery B, a battery management unit 3 that manages a charging status of the battery B, a pulse signal generation unit 4 that superimposes a pulse current or a voltage on the charging current or voltage at one or more charging points according to the charging status of the battery B and supplies the resultant current or voltage to the battery, an internal resistance calculation unit 5 that calculates the internal resistance of the battery B from a current value and a voltage value of the battery at time of supplying the charging current or voltage on which the pulse current or voltage is superimposed, and a data management unit 6 that records, in a memory, the internal resistance calculated by the internal resistance calculation unit 5.

## Description

### Technical Field

The present invention relates to a battery charging device, a battery charging method, and a battery charging program.

### Background Art

An internal resistance of a battery gradually increases as the battery is repeatedly charged and discharged, which causes a decrease in output of the battery. Therefore, measuring the internal resistance of the battery and using the measured internal resistance as an index of a degree of battery degradation are considered.

As a method for measuring the internal resistance of the battery, a current interruption method is used as disclosed in Patent Literature 1. A direct current is caused to flow through the battery and, from a change in voltage at that time, the internal resistance is calculated using Ohm's law.

Here, the internal resistance of the battery is dependent on a state of charge (SOC) of the battery. Therefore, in order to use the internal resistance of the battery as the index of the degree of battery degradation, it is necessary to measure the internal resistance in a plurality of SOCs.

However, in order to measure the internal resistance in the plurality of SOCs, it is necessary to adjust the battery to each of the plurality of SOCs and it takes much time to measure the internal resistance for each of the plurality of SOCs.

### Citation List

### Patent Literature

Patent Literature 1: JP 2021-140991 A

### Summary of Invention

### Technical Problem

Therefore, the present invention has been made in view of the above-described problems, and a main object thereof is to efficiently measure an internal resistance used as a degradation index of a battery at the time of charging the battery.

### Solution to Problem

That is, a battery charging device according to the present invention includes: a battery charging unit that supplies a charging current and/or voltage to a battery; a battery management unit that manages a charging status of the battery; a pulse signal generation unit that superimposes a pulse current or voltage on the charging current or voltage at one or more charging points according to the charging status of the battery and supplies the resultant current or voltage to the battery; an internal resistance calculation unit that calculates an internal resistance of the battery from a current value and a voltage value of the battery at time of supplying the charging current or voltage on which the pulse current or voltage is superimposed; and a data management unit that records, in a memory, the internal resistance calculated by the internal resistance calculation unit.

In such a battery charging device, at the time of charging the battery, the pulse current or voltage is superimposed on the charging current or voltage at one or more charging points corresponding to the charging status and the resultant current or voltage is supplied to the battery, and the internal resistance is calculated from the current value and the voltage value of the battery at time of supplying the pulse current or voltage, so that the internal resistance used as the degradation index of the battery can be efficiently measured at the time of charging the battery. In addition, since the calculated internal resistance is recorded in the memory by the data management unit, the internal resistance for each charge cycle at each of the plurality of charging points can be managed, and progress of degradation of the battery can be monitored.

Here, at one charging point, there is a case where the charging point is not passed during charging (a case where the charging point does not become active) depending on the charging status of the battery (e.g., a state of charge (SOC) of the battery, a filling rate (FR) of lithium ions in an active material, or the like) at the start of charging, and thus, it is desirable to set a plurality of charging points. Further, the charging point is desirably set on the basis of the state of charge, the filling rate, an integrated charge amount, a charging time from the start of charging, and a voltage and/or a current of the battery.

Although the progress of degradation of the battery can be determined by monitoring the calculated internal resistance, in order to make it easier to determine the progress of degradation of the battery, the battery charging device of the present invention preferably further includes a degradation index calculation unit that calculates a degradation index of the battery on the basis of a plurality of internal resistances calculated in a plurality of charge cycles.

As a specific aspect of embodiment of the degradation index calculation unit, it is desirable that the degradation index calculation unit calculates the degradation index of the battery on the basis of the internal resistance calculated at the same charging point in the plurality of charge cycles.

In the battery, the active material expands and contracts due to charging and discharging, and breaks. When the active material breaks, the conductive path becomes narrow, and the internal resistance increases. The amount of increase in internal resistance due to the breakage of the active material is the index of the degree of battery degradation. Therefore, the degradation index calculation unit desirably calculates, as the degradation index, an amount of resistance increase of an internal resistance calculated in a present charge cycle with respect to an internal resistance calculated in a past charge cycle.

Here, the internal resistance calculated in the past charge cycle may be an internal resistance calculated in the previous (latest) charge cycle, an internal resistance calculated in a charge cycle before a predetermined number of times, or an internal resistance calculated in a reference charge cycle such as the first charge cycle.

As a specific aspect of embodiment of superimposing the pulse current or voltage on the charging current or voltage, it is desirable that the pulse signal generation unit superimposes the pulse current or voltage with a negative value on the charging current or voltage.

It is desirable that the battery is a lithium-ion battery and that the pulse signal generation unit superimposes the pulse current or voltage on the charging current or voltage and supply the resultant current or voltage to the battery at the charging point based on a state of charge (SOC) of the battery or a filling rate (FR) of lithium ions in an active material. In addition, the charging point may be based on the integrated charge amount of the battery, the charging time from the start of charging, the voltage or the current of the battery, or the like.

Here, the calculation of the internal resistance for each charging point has the following reason.

The internal resistance of the lithium-ion battery includes an insertion/detachment resistance of lithium ions not related to degradation, and the insertion/detachment resistance depends on a state of charge (SOC) of the battery or a filling rate (FR) of lithium ions in the active material.

Therefore, by comparing the internal resistances calculated at the same charging point in a plurality of charge cycles, how much degradation the battery has, independent of the insertion/detachment resistance, can be confirmed.

The battery reduces its capacity by repeating charging and discharging. Therefore, when the charging point is set based on the SOC of the battery, the charging point is shifted by repeating charging and discharging. Therefore, it is desirable that the battery management unit update the capacity of the battery and manage the charging status of the battery.

The internal resistance changes under the influence of the temperature of the battery or the ambient temperature of the battery. Therefore, in order to accurately obtain the internal resistance, the battery charging device of the present invention preferably further includes a temperature correction unit that corrects the internal resistance calculated by the internal resistance calculation unit on a basis of a temperature of the battery or an ambient temperature of the battery.

Here, a temperature range for calculating the internal resistance may be set without performing temperature correction. That is, the internal resistance of the battery includes the ion migration resistance in electrolyte and the ohmic resistance of the current collector, which are not related to the degradation, and both depend on the temperature. Therefore, a temperature range that has little influence on the ion migration resistance and the ohmic resistance may be set, and the internal resistance calculated outside the range may not be recorded in the data storage unit.

Further, a battery charging method according to the present invention is a battery charging method for charging a battery, the method including: superimposing a pulse current or voltage on a charging current or voltage at one or more charging points according to a charging status of the battery and supplying the resultant current or voltage to the battery; calculating an internal resistance of the battery from a current value and a voltage value of the battery at time of supplying the charging current or voltage on which the pulse current or voltage is superimposed; and recording the internal resistance calculated.

Furthermore, a battery charging program according to the present invention is a battery charging program for charging a battery, the battery charging program including: a function as a charge control unit that controls a battery charging circuit to supply a charging current or voltage to the battery, and superimposes a pulse current or voltage on the charging current or voltage at one or more charging points according to a charging status of the battery and supplies the resultant current or voltage to the battery; a function as an internal resistance calculation unit that calculates an internal resistance of the battery from a current value and a voltage value of the battery at time of supplying the charging current or voltage on which the pulse current or voltage is superimposed; and a function as a data management unit that records, in a memory, the internal resistance calculated by the internal resistance calculation unit.

### Advantageous Effects of Invention

According to the present invention described above, the internal resistance used as the degradation index of the battery can be efficiently measured at the time of charging the battery.

### Brief Description of Drawings

FIG.1 is an overall schematic diagram of a battery charging device according to an embodiment of the present invention.
FIG. 2 is a diagram showing a charging current (a pulse current.) and a battery voltage of the same embodiment.
FIG. 3 is a table showing the internal resistance of each SOC and the rate of increase in the internal resistance for each number of times of charging in the same embodiment.
FIG. 4 is a table showing the internal resistance of each FR and the rate of increase in the internal resistance for each number of times of charging in the same embodiment.
FIG. 5 is a flowchart of a battery charging method of the same embodiment.
FIG. 6 is an overall schematic diagram of a battery charging device according to a modified embodiment.

### Description of Embodiments

### <One embodiment of present invention>

Hereinafter, an embodiment of a battery charging device according to the present invention will be described with reference to the drawings.

Note that any of the drawings shown below is schematically omitted or exaggerated as appropriate for easy understanding. The same components are denoted by the same reference numerals, and the description thereof will be omitted as appropriate.

### <Basic configuration of battery charging device 100>

The battery charging device 100 of the present embodiment makes it possible to determine how much a secondary battery (hereinafter, simply referred to as a battery B) such as a lithium-ion battery has been degraded while charging the battery B. In the present embodiment, as will be described later, the battery charging device 100 calculates a degradation index that is an index of the degree of degradation of the battery B and, thereby, the user can determine how much the battery B has been degraded.

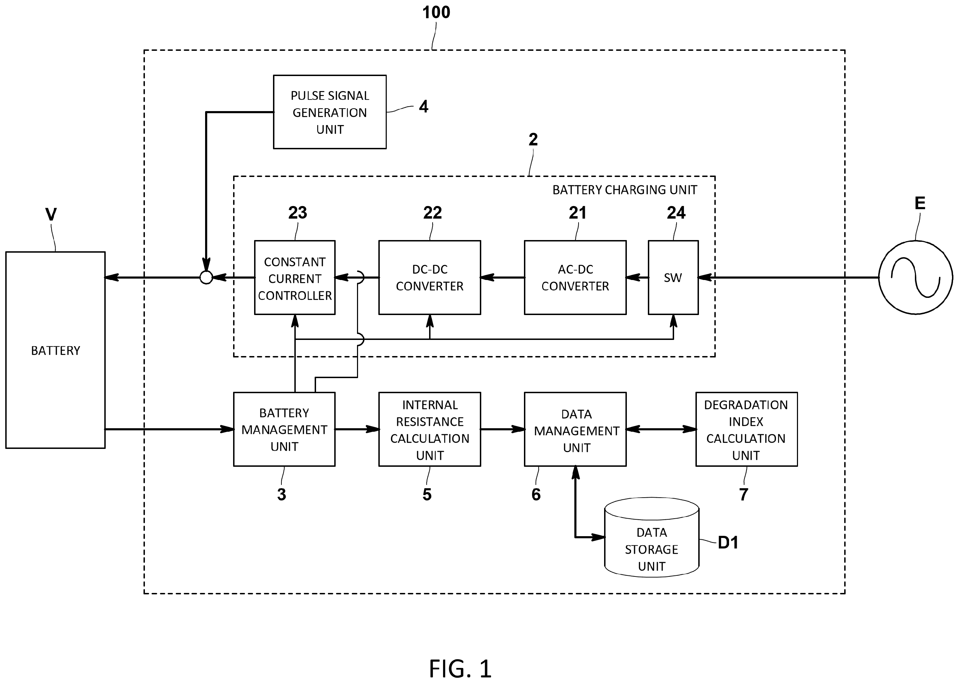

Specifically, the battery charging device 100 charges the battery B by a constant-current charging method, and includes a battery charging unit 2 that supplies a charging current to the battery B and a battery management unit 3 that manages a charging status of the battery B as illustrated in FIG. 1.

The battery charging unit 2 includes an AC-DC converter 21 that converts an AC voltage from the AC power supply E into a DC voltage, a DC-DC converter 22 that adjusts the voltage of the DC voltage, and a constant current controller 23 that makes the voltage-adjusted DC voltage a constant current and supplies the constant current to the battery B. An opening/closing switch 24 is provided between the AC-DC converter 21 and the AC power supply E.

The battery management unit 3 is a so-called battery management system (BMS), and can measure a current flowing through the battery B, a voltage of the battery B, and the like to calculate a state of charge (SOC) of the battery B or a filling rate (FR) of lithium ions in the active material. The battery management unit 3 also functions as a charge control unit that charges the battery B by controlling the battery charging unit 2.

### <Function of calculating degradation index of battery B>

The battery charging device 100 of the present embodiment is configured to be able to calculate a degradation index of the battery B.

Specifically, the battery charging device 100 includes a pulse signal generation unit 4 that superimposes a pulse current on a charging current at a charging point according to the charging status of the battery B and supplies the resultant current to the battery B, an internal resistance calculation unit 5 that calculates an internal resistance of the battery B from a current value and a voltage value of the battery B at time of supplying the charging current on which the pulse current is superimposed, and a data management unit 6 that records the internal resistance calculated by the internal resistance calculation unit 5 in a memory.

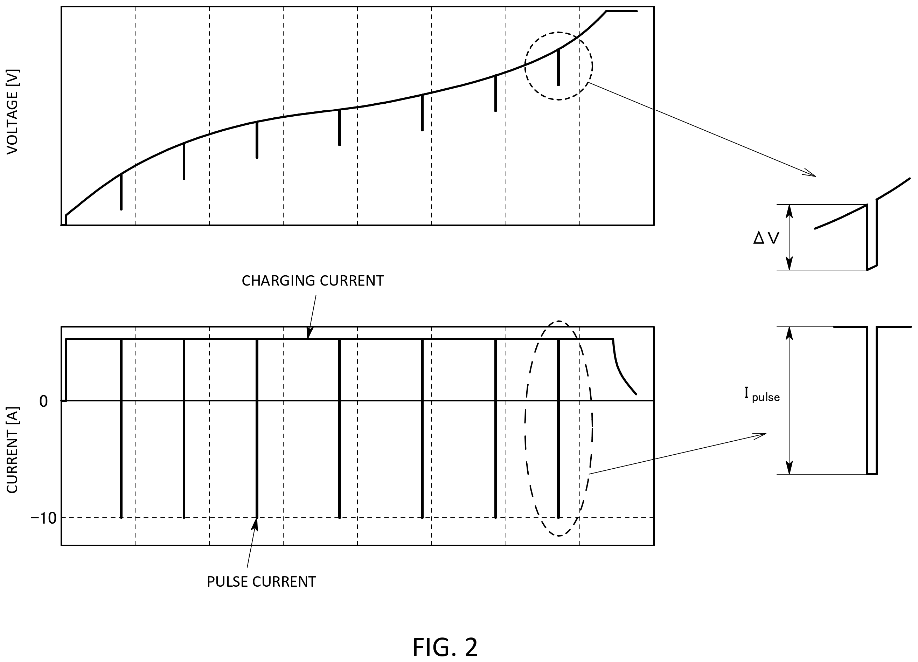

The pulse signal generation unit 4 superimposes the pulse current on the charging current supplied by the battery charging unit 2 and supplies the resultant pulse current to the battery B. As illustrated in FIG. 2, the pulse signal generation unit 4 of the present embodiment superimposes a negative pulse current on the charging current. When the negative pulse current is superimposed on the charging current, the entire current including the superimposed pulse current is a negative current. By superimposing such a negative pulse current, an overvoltage is not applied to the battery B.

The pulse signal generation unit 4 superimposes the pulse current on the charging current and supplies the resultant current to the battery B at a plurality of charging points based on the state of charge (SOC) of the battery B or the filling rate (FR) of lithium ions in the active material. The pulse signal generation unit 4 is controlled by the battery management unit 3. The charging points may be based on not only the state of charge (SOC) of the battery B or the filling rate (FR) of lithium ions in the active material but also an integrated charge amount of the battery B, a charging time from the start of charging, the voltage or the current of the battery, or the like.

Here, the filling rate (FR) of lithium ions in the active material is defined by the following formula as an absolute reference, unlike SOC as a relative reference. $FR = {Q}_{i} ⋅ SOC / {Q}_{0}$

Here, SOC = SOC₀ + (1/Qᵢ) · ∫Idt

In addition, Qᵢ is a capacity (i is the number of updates, and i = 0, 1, 2, 3, ...), Q₀ is an initial capacity, SOC₀ is an SOC at the start of charging, and I is a charging current.

For example, when the initial capacity Q₀ is set to 10Ah and the charging point based on the filling rate FR is set to "0.5", the charging point based on the SOC in the state where the capacity is not degraded (not updated) is "0.5", which is the same as the check point of the filling rate FR.

From the equation FR = Qᵢ · SOC/Q₀, 0.5 = 10 · SOC/10. That is, SOC = 0.5.

On the other hand, when the capacity decreases to 8Ah due to aging degradation, the charging point based on the filling rate FR is fixed at "0.5" because of the absolute reference, but the charging point based on the SOC increases to "0.625".

From the equation FR = Qᵢ · SOC/Q₀, 0.5 = 8 · SOC/10. That is, SOC = 0.625.

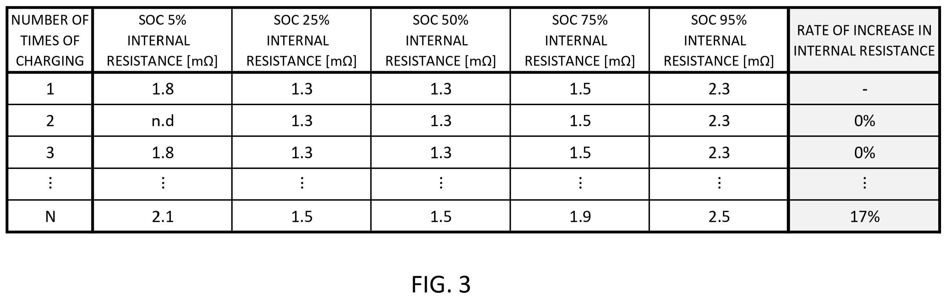

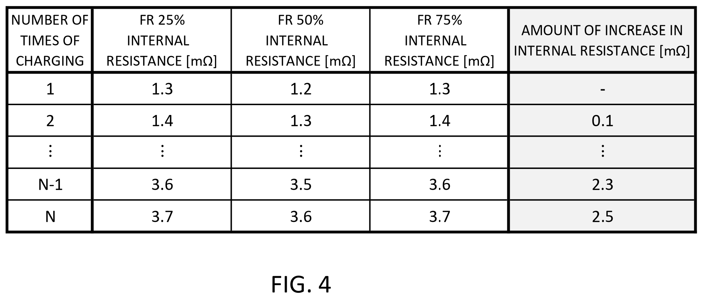

In the case of the SOC, the plurality of charging points for calculating the internal resistance are, for example, a time point of the SOC of 5%, a time point of the SOC of 25%, a time point of the SOC of 50%, a time point of the SOC of 75%, a time point of the SOC of 95%, and the like as illustrated in FIG. 3. In addition, in the case of FR, as illustrated in FIG. 4, the plurality of charging points are, for example, a time point of FR of 25%, a time point of FR of 50%, a time point of FR of 75%, and the like. Whether or not each charging point is reached is determined by the battery management unit 3. When the battery management unit 3 determines that each charging point is reached, the battery management unit 3 transmits an output command to the pulse signal generation unit 4, and the pulse current is superimposed on the charging current by the pulse signal generation unit 4.

The internal resistance calculation unit 5 calculates the internal resistance of the battery B from the current value and the voltage value of the battery B at the time of supplying the charging current on which the pulse current is superimposed. Specifically, as illustrated in FIG. 2, the internal resistance calculation unit 5 calculates the internal resistance R (= ΔV/Iₚᵤₗₛₑ) from the voltage drop ΔV caused by the pulse current and the amplitude Iₚᵤₗₛₑ of the pulse current. The internal resistance calculation unit 5 calculates the internal resistance every time the pulse current is supplied to the battery B by the pulse signal generation unit 4.

The data management unit 6 records the internal resistance calculated by the internal resistance calculation unit 5 in a data storage unit D1 including a memory. Specifically, the data management unit 6 associates the internal resistance calculated by the internal resistance calculation unit 5 with the number of times of charging and/or each charging point of the battery B and records them in the data storage unit D1. Here, when the temperature at the time of charging is out of a specified temperature range (for example, 10 to 40°C), the calculated internal resistance may not be stored in the data storage unit D1. That is, in the data storage unit D1, the internal resistance of the charging point is no data. Note that the data storage unit D1 may be provided in the battery charging device 100 or may be provided outside the battery charging device 100. The data management unit 6 may acquire and store the internal pressure or the ambient pressure of the battery B or the temperature or the ambient temperature of the battery B.

Furthermore, the battery charging device 100 of the present embodiment may further include a degradation index calculation unit 7 that calculates a degradation index that is an index of the degree of degradation of the battery B on the basis of a plurality of internal resistances calculated in a plurality of charge cycles.

The degradation index calculation unit 7 calculates the degradation index of the battery B on the basis of the internal resistance calculated at the same charging point in a plurality of charge cycles.

Specifically, the degradation index calculation unit 7 calculates, as the degradation index, the amount of resistance increase in the internal resistance calculated in the present charge cycle with respect to the internal resistance calculated in the past charge cycle. Here, the past charge cycle may be, for example, the previous charge cycle, a charge cycle a predetermined number of times before, or a reference charge cycle such as the first charge cycle. In the following description, the rate of increase in the internal resistance of the present charge cycle with respect to the internal resistance of the past charge cycle is calculated as the amount of resistance increase. However, the amount of resistance increase may be a difference between the internal resistance of the present charge cycle and the internal resistance of the past charge cycle.

In the present embodiment, the degradation index calculation unit 7 calculates the resistance rate of increase of the internal resistance calculated in the present charge cycle with respect to the internal resistance calculated in the previous charge cycle at each charging point. Then, the degradation index calculation unit 7 uses the average value or the median value of the resistance rate of increases at the respective charging points in the present charge cycle as the degradation index of the battery B. The degradation index calculated by the degradation index calculation unit 7 is recorded in the data storage unit D1 by the data management unit 6 in association with the number of times of charging of the battery B.

In addition, the degradation index calculation unit 7 may use a value calculated by the following as the degradation index.

The degradation index calculation unit 7 obtains an average value or a median value of the internal resistances calculated at the respective charging points in the previous charge cycle, and obtains an average value or a median value of the internal resistances calculated at the respective charging points in the present charge cycle. Then, the degradation index calculation unit 7 calculates a resistance rate of increase of the average value or the median value of the internal resistance of the present charge cycle with respect to the average value or the median value of the internal resistance of the previous charge cycle, and uses the resistance rate of increase as the degradation index.

### <Specific example of battery charging method>

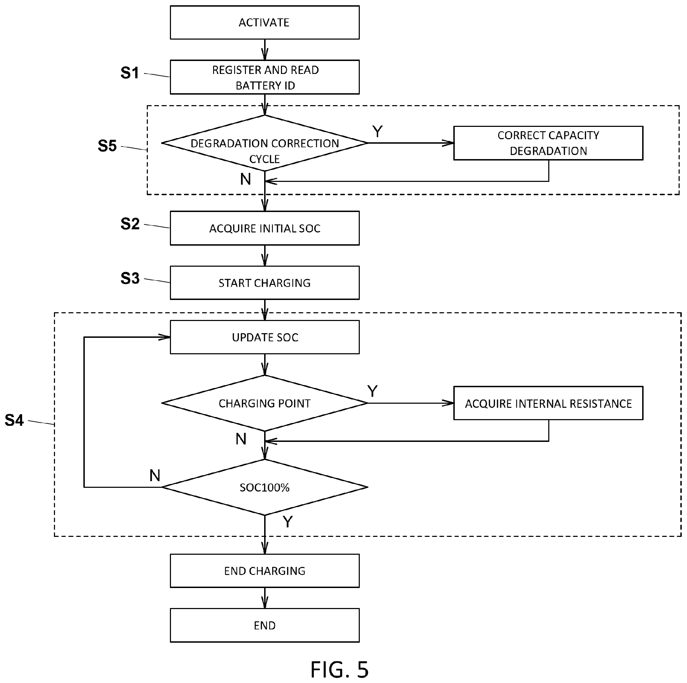

Next, a specific example of a battery charging method using the battery charging device 100 will be described with reference to FIG. 5.

First, the ID (identifier) of the battery B for the first charging is registered in the memory (database) inside the battery charging device 100 (step S1). The battery ID may be read from an ID set in advance in the battery management unit 3 and registered in the memory (database), or may be set by the user and registered in the memory (database).

Then, when the battery B with the ID that has been registered is connected to the battery charging device 100, an initial SOC of the battery B is acquired (step S2). Then, the battery charging device 100 starts charging (step S3), measures the internal resistance at a plurality of predetermined charging points, and the data management unit 6 records the measured internal resistances in the data storage unit D1 (step S4). Similarly, in the second and subsequent charging, the internal resistance is measured at a plurality of predetermined charging points and recorded in the data storage unit D1 by the data management unit 6. Here, in the second and subsequent charge cycles, the amount of resistance increase in the internal resistance in each charge cycle is calculated and recorded in the data storage unit D1 by the data management unit 6.

Here, in the second and subsequent charging, the capacity of the battery B can be corrected every predetermined charge cycles (the capacity correction) (step S5). This capacity correction may be updated by reacquiring the capacity of the battery B by the capacity test, or may be updated by correcting the capacity from the root law or the tendency of the aging degradation test. The capacity correction may be updated by reacquiring the SOC-OCV curve obtained by the SOC-OCV test, or the SOC-OCV curve may be corrected from the corrected capacity obtained by the capacity test.

In this manner, the internal resistance and the amount of resistance increase of each battery B recorded in the data storage unit D1 by the data management unit 6 can be output to a display or the like when the user inputs the ID of the battery B. Here, as the content displayed on the display, for example, one axis (horizontal axis) may be a graph of the number of times of charging and the other axis (vertical axis) may be a graph of the internal resistance, a diagram in which the internal resistance at each charging point is displayed in a table form, or a diagram in which the amount of resistance increase in the internal resistance in each charge cycle is displayed in a table form.

### <Effects of present embodiment>

According to the battery charging device 100 of the present embodiment configured as described above, at the time of charging the battery B, the pulse current is superimposed on the charging current at one or more charging points corresponding to the charging status and the resultant current is supplied to the battery B, and the internal resistance is calculated from the current value and the voltage value of the battery B at time of supplying the pulse current, so that the internal resistance used as the degradation index of the battery B can be efficiently measured at the time of charging the battery B. In addition, since the calculated internal resistance is recorded in the data storage unit D1 by the data management unit 6, the internal resistance for each charge cycle at each of the plurality of charging points can be managed, and progress of degradation of the battery B can be monitored.

### <Other embodiments>

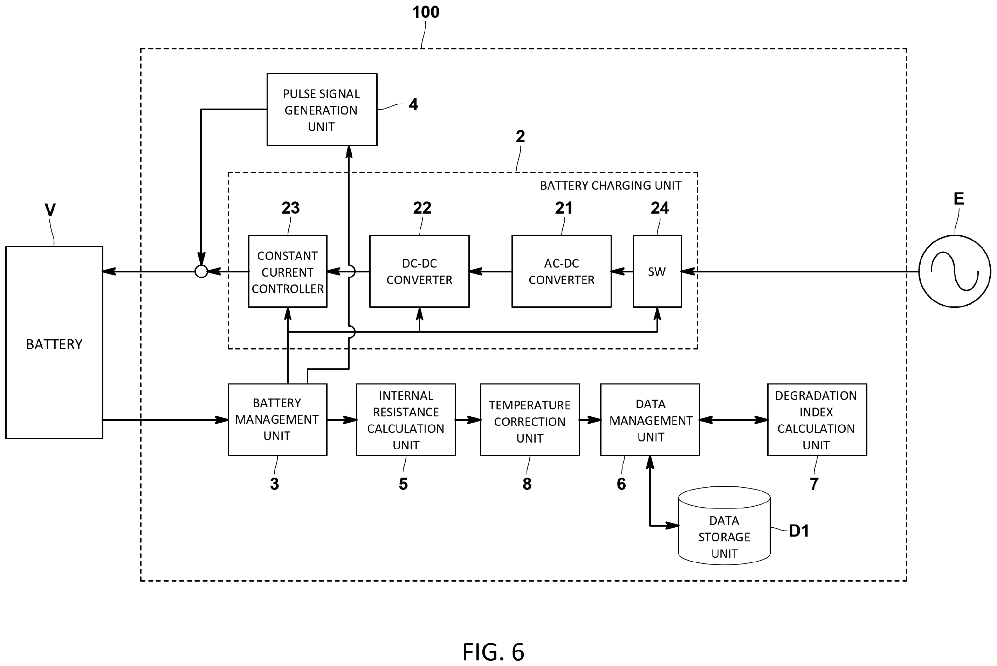

For example, in addition to the configuration of the above embodiment, as shown in FIG. 6, the battery charging device 100 may further include a temperature correction unit 8 that corrects the internal resistance calculated by the internal resistance calculation unit 5 on the basis of the temperature of the battery B or the ambient temperature of the battery B. In this case, the temperature correction unit 8 corrects the internal resistance Rₘₛᵣ before correction calculated by the internal resistance calculation unit 5 using the difference ΔT between the ambient temperature T_{amb} and the reference temperature T_{std} and the temperature characteristic coefficient K_{gra} of the internal resistance of the battery to calculate the corrected internal resistance R_{cor}. Specifically, the temperature correction unit 8 calculates the corrected internal resistance R_{cor} using an equation of R_{cor} = Rₘₛᵣ +K_{gra}× (T_{amb} - T_{std}). The corrected internal resistance is recorded in the data storage unit D1 by the data management unit 6 in association with the number of times of charging of the battery B and each charging point.

Further, the lithium-ion battery of the above embodiment may be mounted on a moving body such as an automobile, a ship, an airplane, a forklift, or an automatic conveyance vehicle (AGV), or may be a stationary type such as communication equipment, security equipment, or a facility, or an emergency power supply.

Furthermore, the battery charging device 100 according to the above-described embodiment may be configured to calculate an index of the degree of degradation while charging not only the lithium-ion battery but also a lead-acid battery, a nickel-metal hydride battery, a nickel-cadmium battery, and/or an all-solid-state battery. In addition, the battery charging device 100 of the above embodiment may calculate an index of the degree of degradation while charging a next generation battery such as a sodium ion battery, a lithium-air battery, a metal lithium load battery, a lithium sulfur battery, or a fluoride battery.

In addition, in the above embodiment, the internal resistance is calculated at a plurality of charging points, but the internal resistance may be calculated at one charging point. In addition, the number of charging points for calculating the internal resistance may be changed or the charging point may be changed, depending on how much the battery has been degraded.

Although one battery B is charged in the above embodiment, a plurality of batteries B may be charged. In this case, it is conceivable that the battery charging device 100 is provided with a plurality of battery charging units 2 and pulse signal generation units 4 corresponding to the respective batteries B, and that the battery charging device 100 includes: an internal resistance calculation unit 5 that calculates internal resistances of the plurality of batteries from current values and voltage values of the plurality of batteries B; and a data management unit 6 that records, in a memory, the internal resistances calculated by the internal resistance calculation unit 5. In this case, each of the plurality of batteries B is managed by an ID, and charge information, internal resistance information, degradation information, or the like of each battery B can be managed regardless of the battery charging unit 2 to be connected. The central control device may be configured to manage a plurality of the battery charging devices 100.

Furthermore, the battery charging device 100 of the above embodiment may include a display unit that displays a charging status of the battery B or various data stored in the data storage unit D1.

The battery charging device of the above embodiment is of a constant-current charging method and supplies a charging current and a pulse current to the battery. However, as long as the battery charging device is of the constant-voltage charging method, the battery charging device may supply a charging voltage and a pulse voltage to the battery. In addition, the battery charging device may be configured to be switchable between a constant-current charging method and a constant voltage charging method.

In addition, various modifications and combinations of the embodiments may be made without departing from the gist of the present invention.

### Industrial Applicability

According to the present invention, the internal resistance used as the degradation index of the battery can be efficiently measured at the time of charging the battery.

### Reference Signs List

- 100: battery charging device
- B: battery
- 2: battery charging unit
- 3: battery management unit (charge control unit)
- 4: pulse signal generation unit
- 5: internal resistance calculation unit
- 6: data management unit
- D1: data storage unit
- 7: degradation index calculation unit
- 8: temperature correction unit

## Claims

1. A battery charging device comprising:
a battery charging unit that supplies a charging current and/or voltage to a battery;
a battery management unit that manages a charging status of the battery;
a pulse signal generation unit that superimposes a pulse current or voltage on the charging current or voltage at one or more charging points according to the charging status of the battery and supplies the resultant current or voltage to the battery;
an internal resistance calculation unit that calculates an internal resistance of the battery from a current value and a voltage value of the battery at time of supplying the charging current or voltage on which the pulse current or voltage is superimposed; and
a data management unit that records, in a memory, the internal resistance calculated by the internal resistance calculation unit.

2. The battery charging device according to claim 1, further comprising a degradation index calculation unit that calculates a degradation index of the battery on a basis of a plurality of internal resistances calculated in a plurality of charge cycles.

3. The battery charging device according to claim 2, wherein the degradation index calculation unit calculates the degradation index of the battery on a basis of the internal resistances that are calculated at a same charging point in the plurality of charge cycles.

4. The battery charging device according to any one of claims 1 to 3, wherein the charging point is set on a basis of a state of charge, a filling rate, an integrated charge amount, a charging time from a start of charging, and a voltage and/or a current of the battery.

5. The battery charging device according to claim 2 or 3, wherein the degradation index calculation unit calculates, as the degradation index, an amount of resistance increase of an internal resistance calculated in a present charge cycle with respect to an internal resistance calculated in a past charge cycle.

6. The battery charging device according to any one of claims 1 to 5, wherein the pulse signal generation unit superimposes the pulse current or voltage with a negative value on the charging current or voltage.

7. The battery charging device according to any one of claims 1 to 6, wherein
the battery is a lithium-ion battery, and
the pulse signal generation unit superimposes the pulse current or voltage on the charging current or voltage and supplies the resultant current or voltage to the battery at the charging point based on a state of charge of the battery or a filling rate of lithium ions in an active material.

8. The battery charging device according to any one of claims 1 to 7, wherein the battery management unit updates a capacity of the battery and manages the charging status of the battery.

9. The battery charging device according to any one of claims 1 to 8, further comprising a temperature correction unit that corrects the internal resistance calculated by the internal resistance calculation unit on a basis of a temperature of the battery or an ambient temperature of the battery.

10. A battery charging method for charging a battery, the method comprising:
superimposing a pulse current or voltage on a charging current or voltage at one or more charging points according to a charging status of the battery and supplying the resultant current or voltage to the battery;
calculating an internal resistance of the battery from a current value and a voltage value of the battery at time of supplying the charging current or voltage on which the pulse current or voltage is superimposed; and
recording the internal resistance calculated.

11. A battery charging program for charging a battery, the battery charging program comprising:
a function as a charge control unit that controls a battery charging circuit to supply a charging current or voltage to the battery, and superimposes a pulse current or voltage on the charging current or voltage at one or more charging points according to a charging status of the battery and supplies the resultant current or voltage to the battery;
a function as an internal resistance calculation unit that calculates an internal resistance of the battery from a current value and a voltage value of the battery at time of supplying the charging current or voltage on which the pulse current or voltage is superimposed; and
a function as a data management unit that records, in a memory, the internal resistance calculated by the internal resistance calculation unit.
